# EUROPEAN PATENT APPLICATION

(11) **EP 1 399 006 A2**
(43) Date of publication of application: **17.03.2004**
(21) Application number: 03255690.4
(22) Date of filing: 11.09.2003
(51) Int. Cl.: H05K 1/14, H05K 3/34, H05K 9/00

(54) **A mounting structure of a wireless module**

(30) Priority: 13.09.2002 JP 2002005833
(71) Applicant: ALPS ELECTRIC CO., LTD., Ota-ku Tokyo 145 (JP)
(72) Inventor: Watanabe, Hideki, Tokyo 145 (JP); Matsuno, Satoru, Tokyo 145 (JP)
(74) Representative: Kensett, John Hinton

(57) **Abstract**

A mounting structure of a wireless module having low cost and excellent productivity is provided. In the mounting structure of a wireless module according to the present, a cover (4) has a box-shaped cover portion (4a) and one or a plurality of leg portions (4b) projected downward from the cover portion (4a). First through holes 1a for inserting the leg portions (4b) are provided in the circuit board (1), and second through holes (6a) for inserting the leg portions (4b) are provided in the motherboard (6). Since the leg portions (4b) are soldered to the circuit board (1) and the motherboard (6) at the first and second through holes (1a, 6a) in a state that the leg portions (4b) are inserted into the first and second through holes (1a, 6a), respectively, the cover (4) also serves as the conventional protective cover. Therefore, this invention has less components than the conventional art, decreases the cost, simplifies the mounting process of the cover, and thus provides excellent productivity.

## Description

### BACKGROUND OF THE INVENTION

### 1. Field of the Invention

The present invention relates to a mounting structure of a wireless module suitable to be used in a wireless transceiver such as a potable phone or a personal computer.

### 2. Description of the Related Art

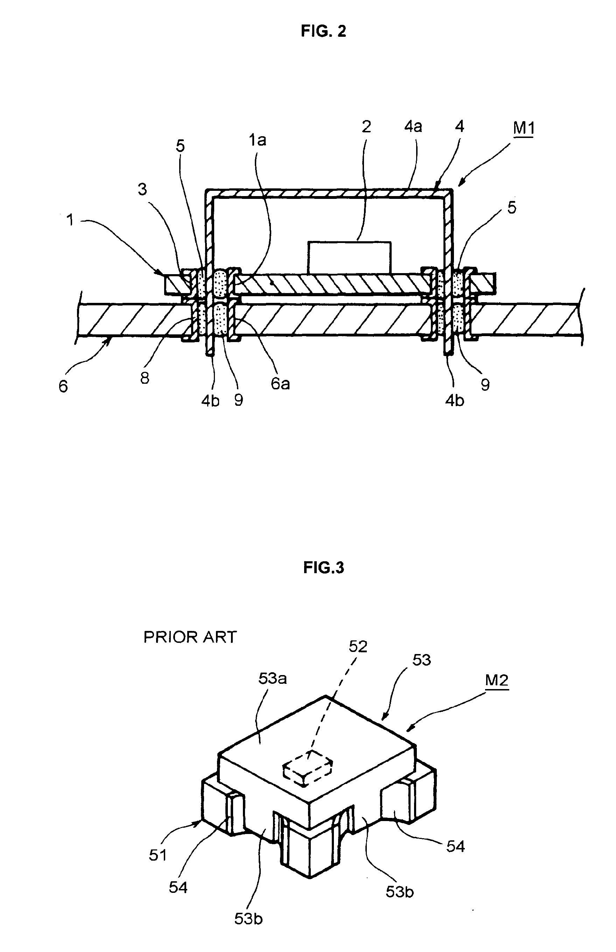

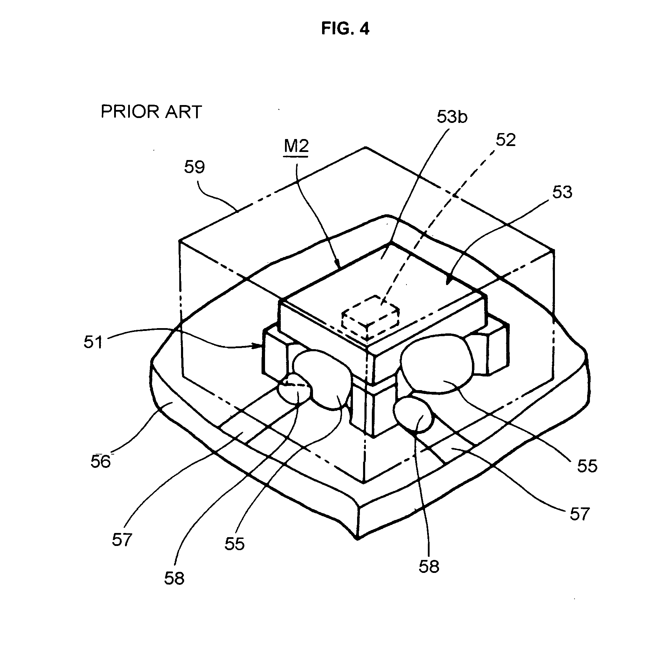

The conventional mounting structure of a wireless module will be explained with reference to the drawings wherein Fig. 3 is a perspective view illustrating a wireless module relating to the conventional mounting structure of a wireless module, and Fig. 4 is a perspective view illustrating the conventional mounting structure of the wireless module.

Next, a configuration of the conventional mounting structure of the wireless module will be described with reference to Figs. 3 and 4. In a circuit board 51 constructed by laminating one sheet or a plurality of sheets, electrical components 52 such as chip type resistors or capacitors including semiconductor components are mounted on its upper surface wherein wiring patterns (not shown) are formed, so that a desired electric circuit comprising a receiving/transmitting circuit is formed.

A.cover 53 made of a solderable metal plate has a box-shaped cover portion 53a and a plurality of attaching pieces 53b projected downward from the lower end of the cover portion 53a. In a state wherein the cover portion 53a of the cover 53 covers the electrical components 52, the cover 53 is attached to the circuit board 51 by soldering solders 55 of the attaching pieces 53b to side electrodes 54 provided in the circuit board 51.

With this configuration, a wireless module M2 is formed (for example, see Japanese Unexamined Patent Application Publication No. 1999-31893).

With such wireless module M2, the circuit board 51, as shown in Fig. 4, is put on a motherboard 56, the circuit board 51 is mounted on conductive patterns 57 of the motherboard 56 with solders 58, and thus the circuit board 51 is electrically connected to the motherboard 56.

In this state, the solders 55 for attaching the cover 53 are externally exposed, and thus the cover 53 can be easily separated by melting the solders 55. As a result, violation such as exchange of memory or alteration of output power in the wireless module M2 becomes easy.

Therefore, conventionally in order to prevent such violation, as shown in Fig. 4, a protective cover 59 for covering the wireless module M2 is provided on the motherboard 56. The protective cover 59 is attached to the motherboard 56 with special screws (not shown) which can be attached and detached by means of a special tool.

In the conventional mounting structure of the wireless module, since the protective cover 59 for covering the wireless module M2 and the special screws for attaching the protective cover 59 to the motherboard 56 are required in order to prevent the violation. Thus, the prior art has problems in that the cost increases due to more components, has some difficulties in attaching the protective 59, and thus lowers the productivity.

### SUMMARY OF THE INVENTION

Therefore, it is an object of the present invention to provide a mounting structure of a wireless module having low cost and excellent productivity.

As a first solving means for solving the above problems, a mounting structure of a wireless module is provided, the mounting structure comprising: a circuit board having electrical components including semiconductor components mounted on its upper surface; a cover attached to the circuit board while covering the electrical components; and a motherboard for mounting the circuit board thereon, wherein the cover has a box-shaped cover portion and one or a plurality of leg portions projected downward from the cover portion, wherein first through holes for inserting the leg portions are provided in the circuit board, and second through holes for inserting the leg portions are provided in the motherboard, and wherein the leg portions are soldered to the circuit board and the motherboard at the first and second through holes or at positions close to the first and second through holes in a state that the leg portions are inserted into the first and second through holes, respectively.

Preferably, the circuit board is put on the motherboard to overlap each other.

Preferably, conductors are provided on the walls of the first and second through holes, and the leg portions are soldered to the conductors.

Preferably, the leg portions extend in a straight line.

An embodiment of the invention will now be described, by way of example only, with reference to the accompanying drawings, in which:
Fig. 1 is a perspective view illustrating a mounting structure of a wireless module according to the present invention;
Fig. 2 is a cross-sectional view illustrating essential parts of the mounting structure of the wireless module according to the present invention;
Fig. 3 is a perspective view illustrating a wireless module relating to the conventional mounting structure of a wireless module; and
Fig. 4 is a perspective view illustrating the conventional mounting structure of the wireless module.

### DESCRIPTION OF THE PREFERRED EMBODIMENTS

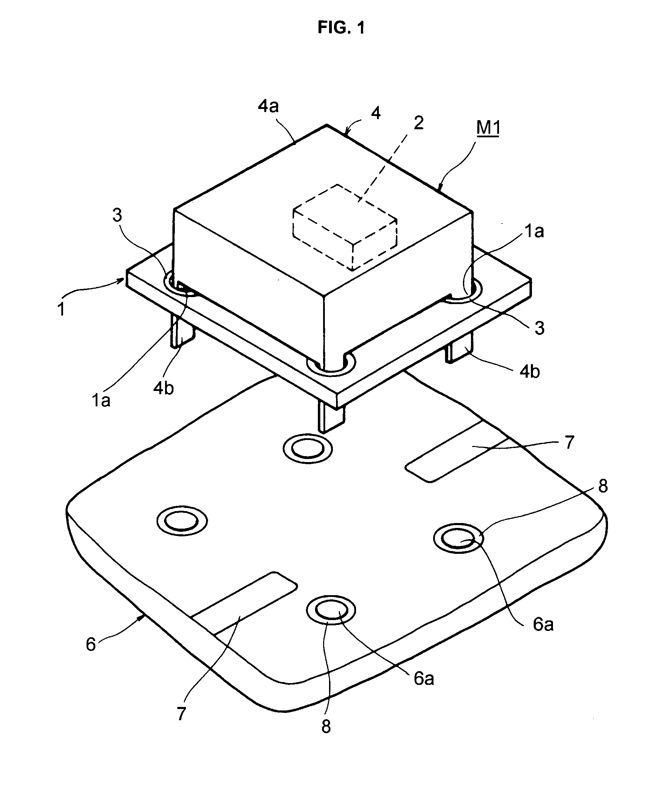

A mounting structure of a wireless module according to the present invention will be explained with reference to the drawings wherein Fig. 1 is a perspective view illustrating a mounting structure of a wireless module according to the present invention, and Fig. 2 is a cross-sectional view illustrating essential parts of the mounting structure of the wireless module according to the present invention.

Next, a configuration of the mounting structure of the wireless module according to the present invention will be described with reference to Figs. 1 and 2. In a circuit board 1 constructed by laminating one sheet or a plurality of sheets, electrical components 2 such as chip type resistors or capacitors including semiconductor components are mounted on its upper surface wherein wiring patterns (not shown) are formed, so that a desired electric circuit comprising a receiving/transmitting circuit is formed.

Further, a plurality of through holes 1a is provided in the circuit board 1, and solderable conductors 3 are provided on the walls of the through holes 1a.

Then, although not shown herein, connection conductors are provided on the lower surface or side surface of the circuit board 1, and thus the circuit board 1 can be electrically connected to the outside thereof through the connection conductors.

A cover 4 made of a solderable metal plate comprises a box-shaped cover portion 4a and a plurality of leg portions 4b provided at corners of the cover portion 4a and projected downward from the lower end of the cover portion 4a in a straight line. In a state wherein the cover portion 4a of the cover 4 covers the electrical components 2, the leg portions 4b are inserted into the through holes 1a, and the leg portions 4b are attached to the circuit board 1 by soldering solders 5 to the conductors 3.

With this configuration, a wireless module M1 is formed.

Further, a motherboard 6 for mounting the circuit board 1 thereon has conductive patterns 7 and a plurality of through holes 6a, and solderable conductors 8 are provided on the walls of the through holes 6a.

Then, the circuit board 1 is put on the motherboard 6 to overlap each other, and the leg portions 4b are inserted into the through holes 6a.

In this state, by soldering the connection conductors of the circuit board 1 to the conductive patterns 7, the circuit board 1 is electrically connected to the motherboard 6, and the leg portions 4b are attached to conductors 8 with solders 9.

The soldering of the circuit board 1 to the motherboard 6 and the soldering of the leg portions 4b to the conductors 8 with the solders 9 are performed in the simultaneous process by using a cream solder.

Furthermore, although the above embodiment has been described that the plurality of leg portions 4b are formed, only one leg portion may be formed.

Further, although the leg portions 4b have been described to extend in a straight line, the leg portions 4b inserted into the through holes 1a may be bent into an L shape on the lower surface side of the circuit board 1, and then the end of the L shape may be inserted into the through holes 6a of the mother substrate 6.

Further, the leg portions 4b may be soldered at positions close to the through holes 1a, 6a.

The mounting structure of the wireless module according to the present invention comprises the circuit board having the electrical components including the semiconductor components mounted on its upper surface; the cover attached to the circuit board while covering the electrical components; and the motherboard for mounting the circuit board thereon, wherein the cover has the box-shaped cover portion and one or a plurality of leg portions projected downward from the cover portion, wherein first through holes for inserting the leg portions are provided in the circuit board, and second through holes for inserting the leg portions are provided in the motherboard, and wherein the leg portions are soldered to the circuit board and the motherboard at the first and second through holes or at positions close to the first and second through holes in a state that the leg portions are inserted into the first and second through holes, respectively. Accordingly, the cover also serves as a conventional protective cover. Therefore, this invention has less components than the conventional art, decreases the cost, simplifies the mounting process of the cover, and thus provides excellent productivity.

Further, since the leg portions are attached in a state wherein the leg portions are inserted into the first and second through holes, it is difficult to peel off the solders of the leg portions. Thus, it is possible to surely prevent the violation.

Further, since the circuit board is put on the motherboard to overlap each other, it becomes more difficult to peel off the solders of the leg portions. Thus, it is possible to prevent the violation with more certainty.

Further, since the conductors are provided on the walls of the first and second through holes and the leg portions are soldered to the conductors, it becomes more difficult to peel off the solders of the leg portions. Thus, it is possible to prevent the violation with more certainty.

Further, since the leg portions extend in a straight line, the cover can be manufactured simply, and it is possible to easily attach the cover to the circuit board and the motherboard, which provides excellent productivity.

## Claims

1. A mounting structure of a wireless module, comprising:
a circuit board having electrical components including semiconductor components mounted on its upper surface;
a cover attached to the circuit board while covering the electrical components; and
a motherboard for mounting the circuit board thereon,
wherein the cover has a box-shaped cover portion and at least one leg portion projected downward from the cover portion,
wherein first through holes for inserting the leg portions are provided in the circuit board, and second through holes for inserting the leg portions are provided in the motherboard, and
wherein the leg portions are soldered to the circuit board and the motherboard at the first and second through holes or at positions close to the first and second through holes in a state wherein the leg portions are inserted into the first and second through holes, respectively.

2. The mounting structure of a wireless module according to claim 1, wherein the circuit board is put on the motherboard to overlap each other.

3. The mounting structure of a wireless module according to claim 1, wherein conductors are provided on the walls of the first and second through holes, and the leg portions are soldered to the conductors.

4. The mounting structure of a wireless module according to claim 1, wherein the leg portions extend in a straight-line shape.
